# EUROPEAN PATENT SPECIFICATION

(11) **EP 4 564 420 B1**
(45) Date of publication and mention of the grant of the patent: **10.06.2026**
(21) Application number: 24215543.0
(22) Date of filing: 26.11.2024
(51) Int. Cl.: H05K 1/185, H05K 3/46, H10W 70/05, H10W 70/60, H10W 70/63, H10W 70/68, H10W 70/69, H10W 70/692, H10W 42/60, H10W 42/80, H10W 70/685, H10W 74/10

(54) **PACKAGING SUBSTRATE AND MANUFACTURING METHOD OF PACKAGING SUBSTRATE**
VERPACKUNGSSUBSTRAT UND HERSTELLUNGSVERFAHREN FÜR VERPACKUNGSSUBSTRAT
SUBSTRAT D'ENCAPSULATION ET PROCÉDÉ DE FABRICATION DE SUBSTRAT D'ENCAPSULATION

(30) Priority: 30.11.2023 US 202363604197 P
(43) Date of publication of application: 04.06.2025
(73) Proprietor: Absolics Inc., Covington, GA 30014 (US)
(72) Inventor: KIM, Sungjin, Covington, GA 30014 (US); KIM, Hyejin, Covington, GA 30014 (US)
(74) Representative: BCKIP Part mbB

(56) References cited:
- US-A1- 2022 051 972
- US-A1- 2022 157 676
- US-A1- 2022 230 948

## Description

### 1. Field

This document relates to a packaging substrate, a semiconductor package, a method for manufacturing a packaging substrate, and a method for manufacturing the semiconductor package.

### 2. Description of Related Art

When building an electronic component, implementing the circuitry on a semiconductor wafer is called the Front-End (FE), and assembling the wafer into a product-ready state is called the Back-End (BE). The latter includes the packaging process.

There are four core technologies in the semiconductor industry that have enabled the rapid development of electronic products in recent years: semiconductor technology, semiconductor packaging technology, manufacturing process technology, and software technology. Semiconductor technology is advancing in various forms, including sub-micron to nano-scale line widths, more than 10 million cells, high-speed operation, and high heat dissipation, but the technology to package them perfectly is relatively weak. Therefore, the electrical performance of semiconductors is often determined by packaging technology and electrical connections rather than the performance of the semiconductor technology itself.

Substrates for packaging may be made of ceramic or resin. Ceramic substrates, such as silicon substrates, have high resistivity or high dielectric constant, making it difficult to mount high-performance, high-frequency semiconductor devices. In the case of resin substrates, it is possible to mount relatively high-performance, high-frequency semiconductor devices. However, there are limitations in reducing the pitch of the wiring.

Recently, silicon or glass may be used as substrates for high-end packaging. By forming through-holes in the silicon or glass substrate and applying conductive materials to the through-holes, the wiring between the element and the motherboard can be shortened and have good electrical characteristics.

In addition, semiconductor packages can generate heat during operation and may further include heat dissipation means to dissipate this heat.

Related Art Documents include Korean Registered Patent No. 10-2543188 and Registered Patent US 11676942 B2.

Document US 2022 / 0 157 676 A1 discloses an integrated circuit package and a method of forming such package. The package includes a substrate having a glass core layer, where the glass core layer includes a first major surface, a second major surface, and a cavity disposed between the first major surface and the second major surface of the glass core layer. The package also includes a die disposed in the cavity of the glass core layer, an encapsulant disposed in the cavity between the die and a sidewall of the cavity, a first patterned conductive layer disposed adjacent the first major surface of the glass core layer, and a second patterned conductive layer disposed adjacent the second major surface of the glass core layer. The die is electrically connected to at least one of the first and second patterned conductive layers.

### SUMMARY OF THE INVENTION

An objective of the present invention is to provide a method for manufacturing a packaging substrate and a packaging substrate using the method for manufacturing the packaging substrate that can reduce an undulation phenomenon that may occur due to a gap between electronic elements and/or a gap between a cavity portion and an electronic element, etc. in a packaging substrate in which a glass substrate is used.

To achieve the above objective, the present invention provides a packaging substrate in accordance with claim 1 and a method of manufacturing a packaging substrate in accordance with claim 10. A packaging substrate according to the present invention includes: a core layer including a glass core having first and second surfaces facing each other; and a cavity portion penetrating the glass core.

The cavity portion has a cavity module and a second insulating layer disposed therein.

The cavity module includes: i) a plurality of electronic elements ii) a first insulating layer; and iii) a third insulating layer.

The first insulating layer is a layer covering each of the electronic elements with a coating material.

The third insulating layer is a layer surrounding a plurality of disposed electronic elements with a molding material.

The first insulating layer is arranged on all or all of the surfaces except one face of each of the electronic elements.

The second insulating layer is embedded in a portion of the cavity portion other than the cavity module.

The first insulating layer and the third insulating layer has different dielectric constants.

The coating material may have a lower dielectric constant than the molding material of the third insulating layer.

The high frequency dielectric constant Dk is the dielectric constant at a high frequency of 5.8 Ghz.

Dk1 is the high frequency dielectric constant of the first insulating layer and Dk3 is the high frequency dielectric constant of the third insulating layer.

The difference between Dk1 and Dk3 may be 0.1 or more.

Df1 is the dielectric loss factor of the first insulating layer and Df3 is the dielectric loss factor of the third insulating layer.

The difference between Df1 and Df3 may be 0.0001 or more.

The first insulating layer has a lower dielectric constant than the second insulating layer.

Df1 is the dielectric dissipation factor of the first insulating layer, and Df2 is the dielectric dissipation factor of the second insulating layer.

The difference between Df1 and Df2 may be 0.1 or more.

The coating material of the first insulating layer may include an inorganic vapor deposition layer, a liquid crystal polymer (LCP), an epoxy molding compound (EMC), an Ajinomoto build-up film (ABF), or a modified polyimide (MPI).

The electronic element may be disposed with an electronic element connection electrode.

The cavity module may include a cavity connection electrode.

The cavity connection electrode is a connection electrode electrically connected to the electronic element connection electrode and exposed on the surface of the cavity module.

The electronic elements may include passive elements, active elements, or both.

The first insulating layer may further include a first insulating layer via through the first insulating layer.

The third insulating layer may further include a third insulating layer via penetrating at least a portion of the third insulating layer.

The first insulating layer via and the third insulating layer via may be partially or wholly filled with conductive material therein.

To achieve the above objectives, a method of manufacturing a packaging substrate according to the present invention includes: preparation operation of preparing a glass substrate in which the cavity portion is arranged and a cavity module; and lamination operation of arranging the cavity module on the cavity portion and preparing a second insulating layer on the glass substrate.

A cavity module includes: i) a plurality of electronic elements; ii) a first insulating layer; and iii) a third insulating layer.

The first insulating layer is a layer covering each of the electronic elements.

The first insulating layer is disposed on all or all but one side of each of the electronic elements.

The third insulating layer includes a molding material and arranged to cover the electronic elements

The second insulating layer is embedded in a portion of the cavity module within the cavity.

The first insulating layer and the third insulating layer has different dielectric constants.

The cavity module may be manufactured by a cavity module manufacturing operation.

The cavity module manufacturing operation includes: an arrangement process for arranging electronic elements adjacent to each other; a first insulation process for providing a first insulation layer on a surface of the arranged electronic elements; and a molding process for molding the electronic elements with the first insulation layer using a molding material to provide a cavity module including a third insulation layer.

The molding material may include EMC (Epoxy Molding Compound), ABF (Ajinomoto Build-up Film), or MPI (Modified Polyimide).

The cavity module manufacturing operation may further include forming the cavity electrodes after the molding process.

The cavity electrode forming process includes removing a portion of the molding material, forming an electrode connected to the connecting electrode of the electronic element, and arranging a cavity module connecting electrode connected to the electrode.

### BRIEF DESCRIPTION OF THE DRAWINGS

FIG. 1 is a conceptual diagram illustrating a cross-sectional structure of a packaging substrate, according to an embodiment.
FIGS. 2A and 2B are conceptual diagrams illustrating a cross-sectional structure of a packaging substrate, according to different embodiments.
FIG. 3A shows conceptual diagrams for explaining a process of generating a cross-sectional structure of the packaging substrate of FIG. 2A. Also, FIG. 3B shows conceptual diagrams for explaining a process of generating the cross-sectional structure of FIG. 2B.
FIG. 4 is a cross-sectional flowchart illustrating a process for creating a core distribution layer during manufacturing of a packaging substrate, according to an embodiment.
FIG. 5 is a cross-sectional flowchart illustrating a process for creating an insulating layer during manufacturing of a packaging substrate, according to an embodiment.
FIG. 6 is an example of a cross-sectional structure of a core layer of a packaging substrate, according to an embodiment not covered by but useful for understanding the present invention.
FIG. 7 is an example of a cross-sectional structure of a core layer of a packaging substrate generated according to another implementation.
FIG. 8 is a cross-sectional flowchart illustrating a method of manufacturing a packaging substrate, according to an embodiment not covered by but useful for understanding the present invention.
FIG. 9 is a cross-sectional flowchart illustrating a method of manufacturing a packaging substrate, according to another embodiment.

### DETAILED DESCRIPTION

In order to provide a comprehensive understanding of the methods, apparatus, and/or systems described herein, the following detailed description is provided. However, various modifications, revisions, and equivalents of the methods, devices, and/or systems described herein will become apparent after understanding what this invention presents. For example, the sequence of operations described herein is by way of example only and is not intended to be limiting to the operations described herein. With the exception of operations that are not necessarily performed in a particular order, the order of operations may be altered based on an understanding of what is disclosed herein. Further, descriptions of features already known in the art may be omitted for clarity and brevity after understanding the invention of this application. However, the omission of such features and their descriptions is not intended to be recognized as general knowledge.

The features described herein may be implemented in different forms and are not to be construed as being limited to the examples described herein. Rather, the embodiments described herein are provided to illustrate some of the many possible ways of implementing the methods, devices, and/or systems described herein that will become apparent after understanding the inventions of this application.

The terms "first," "second," "third," and the like may be used herein to describe various members, components, regions, layers, or sections, but are not intended to limit the members, components, regions, layers, or sections to these words. Instead, these terms are used for the purpose of distinguishing one member, component, region, layer, or section from another member, component, region, layer, or section. Thus, a first member, component, region, layer, or section referred to in the embodiments described herein may also be referred to as a second member, component, region, layer, or section without departing from the teachings of the embodiments.

Throughout the specification, when an element, such as a layer, region, or substrate, is described as being "on," "connected to," or "coupled to" another element, it may be described as being directly "on," "connected to," or "coupled to" the other element, or it may have one or more other elements interposed between them. In contrast, when an element is described as "directly on", "directly connected to", or "directly joined to" another element, no other element can intervene between them. Similarly, for example, expressions such as "between" and "directly between," and "abutting" and "directly abutting" can also be interpreted as described above.

The terms used in this specification are intended to describe specific examples and are not intended to limit the invention. The singular form used herein is intended to include the plural form unless the context clearly indicates otherwise. As used herein, the term "and/or" includes any one or a combination of two or more of the relevant list items. The terms "comprising," "consisting of," and "having" as used herein specify the presence of the specified features, numbers, actions, elements, components, and/or combinations thereof, but do not exclude the presence or addition of one or more other features, numbers, actions, elements, components, and/or combinations thereof. The use of the term "may" in this specification with respect to an example or embodiment (e.g., with respect to what an example or embodiment may include or implement) implies that there is at least one example or embodiment that includes or implements such features, but not all examples are limited thereto.

Throughout the specification, "B being located on A" means that B is placed on top of A, either in direct contact with A or with another layer or structure interposed therebetween, and should not be construed to mean that B is in direct contact with A.

Unless otherwise defined, all terms used herein shall have the same meaning as commonly understood by one of ordinary skill in the art to which the present invention belongs. Such terms, as defined in commonly used dictionaries, shall be construed to have a meaning consistent with their meaning in the context of the prior art and the present invention and shall not be construed in an idealized or overly formal sense unless expressly defined herein.

In one or more of the examples above, a description of "A and/or B" means "A, B, or A and B".

In one or more of the above examples, terms such as "first," "second," "A," or "B" are used to distinguish identical terms from each other.

In one or more of embodiments, a singular form is contextually interpreted to include the plural as well as the singular, unless otherwise noted.

In one or more of embodiments, a coefficient of thermal expansion stated without specific reference to temperature means the coefficient of thermal expansion at room or ambient temperature.

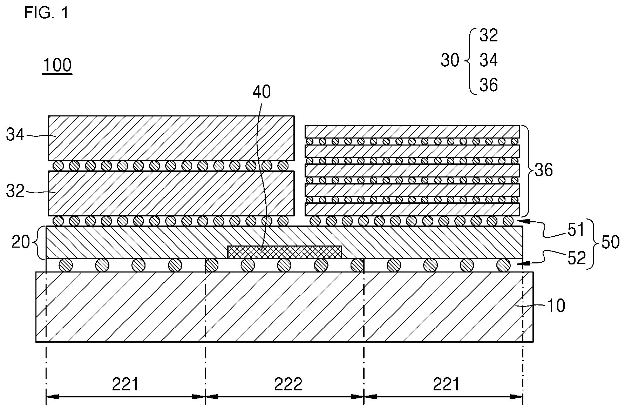

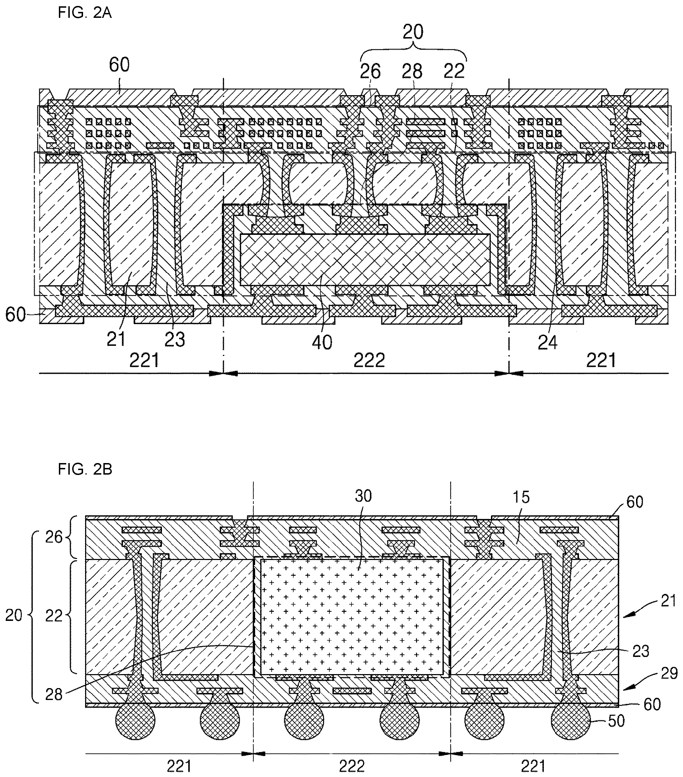

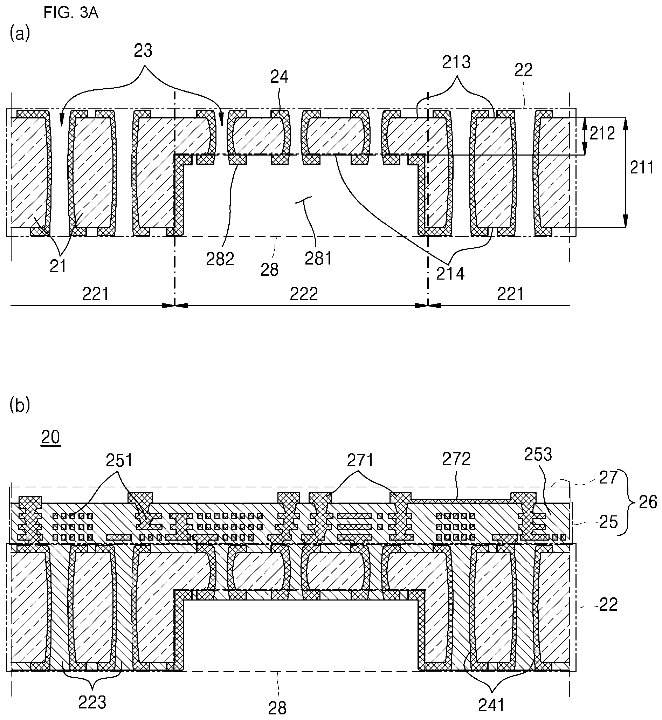

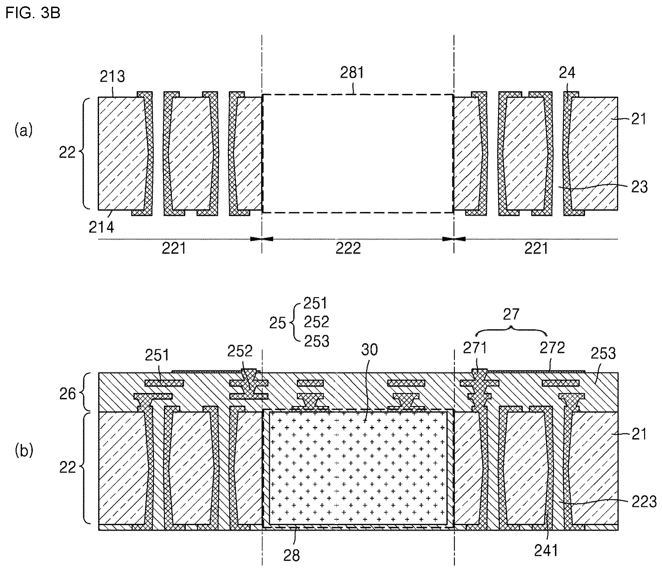

FIG. 1 is a conceptual diagram illustrating a cross-sectional structure of a packaging substrate, according to an embodiment, FIGS. 2A and 2B are conceptual diagrams illustrating a cross-sectional structure of a packaging substrate, according to different embodiments, FIG. 3A shows conceptual diagrams for explaining a process of generating a cross-sectional structure of the packaging substrate of FIG. 2A, and FIG. 3B shows conceptual diagrams for explaining a process of generating the cross-sectional structure of FIG. 2B.

To accomplish the above objectives, a semiconductor device 100 according to an embodiment comprises a semiconductor element portion 30 on which one or more semiconductor elements 32, 34, 36 are located; a packaging substrate 20 electrically connected to the semiconductor elements; and a motherboard 10 electrically connected to the packaging substrate 20 for transmitting external electrical signals to and connecting the semiconductor elements 32, 34, 36 to each other.

The packaging substrate 20 according to one embodiment, comprises a core layer 22, an upper layer 26 located on a first surface of the core layer 22, and a cavity portion 28 in which electronic elements 40 are located. Although FIG. 1 illustrates that the cavity device 40 is disposed at a lower end of the packaging substrate 20, the disposition of the cavity device 40 is not limited thereto.

The semiconductor element portion 30 refers to an element mounted on a semiconductor device and is mounted on the packaging substrate 20 by means of a connection electrode or the like. Specifically, the semiconductor element portion 30 may be applied to, for example, a computing element (first semiconductor element: 32, second semiconductor element: 34) such as a CPU or GPU, a memory element (third semiconductor element, 36) such as a memory chip, etc.

The motherboard 10 may be a motherboard such as a printed circuit board, a printed wiring board, or the like.

The packaging substrate 20 may optionally comprise a lower layer (not shown) positioned below the core layer.

The core layer 22 may comprise; a first zone 221 having a first thickness and a second zone 222 having a second thickness adjacent to the first zone 221 and having a thickness less than the first thickness or having a zero thickness; a plurality of core vias 23 penetrating the glass substrate 21 in a thickness direction, and a core distribution layer 24 located on a surface of the glass substrate 21 or core vias 23 and electrically connecting, via the core vias 23, a first surface 213 of the glass substrate 21 and a second surface 214 facing the first surface 213.

The second zone 222 of the core layer 22 may serve as a cavity structure.

Within the same zone, the glass substrate 21 has a first surface 213 and a second surface 214 that face each other, and these two surfaces are substantially parallel to each other and have a constant thickness throughout the glass substrate 21.

Within the same zone, the glass substrate 21 has a first surface 213 and a second surface 214 facing each other, and these two surfaces are generally parallel to each other and have a constant thickness as a whole of the glass substrate 21.

The inner space 281 formed by the difference in thickness of the first zone 221 and the second zone 222 serves to house some or all of the cavity elements 40. FIGS. 2B and 3B illustrate a full cavity with the glass substrate removed from the second zone. However, embodiments are not limited to this, and half-cavities are also applicable. An example of a half-cavity is shown in FIGS. 2A and 3A.

The glass substrate 21 may comprise a core via 23 through the first surface 213 and the second surface 214. The core vias 23 may be formed in both the first zone 221 and the second zone 222, provided that the second thickness is non-zero, and may be formed in any desired pitch and pattern. Alternatively, if the second thickness is zero, the core via 23 may be formed in the first zone 221 and may be formed in any desired pitch and pattern.

As a packaging substrate for semiconductor devices, silicon substrates and organic substrates have traditionally been applied in a laminated form. In the case of silicon substrates, due to the nature of semiconductors, parasitic elements may occur and power losses are relatively high, when applied to high-speed circuits. In addition, organic substrates require a large area to form more complex distribution patterns, which is inconsistent with the trend of miniaturization of electronic devices. In order to form a complex distribution pattern within a certain size, pattern refinement is practically necessary, but there were practical limitations in pattern refinement due to the characteristics of materials such as polymers applied to organic plates.

In an embodiment, a glass substrate 21 is applied as support for the core layer 22 as a way to address these issues. In addition, a core via 23 formed through the glass substrate 21 is applied along with the glass substrate 21 to provide the packaging substrate 20 with shorter electrical flow lengths, more miniaturization, faster response, and lower loss characteristics.

The glass substrate 21 is preferably a glass substrate applied to semiconductors, and for example, a borosilicate glass substrate, an alkali-free glass substrate, and the like may be applied, but is not limited thereto.

The core via 23 penetrates the glass substrate 21. The core via 23 may be formed in such a way as to remove a predetermined area of the glass substrate 21, in particular by etching the glass substrate by physical and/or chemical means.

Specifically, the formation of the core via 23 may be accomplished by forming defects (inclusions) on the surface of the glass substrate by means of a laser or the like, followed by chemical etching, laser etching, and the like, but is not limited thereto.

Based on a unit area (1 cm x 1 cm) of the glass substrate 21, the number of the core via 23 may be from 100 to 3,000, from 100 to 2,500, or from 225 to 1,024. If such a pitch condition is satisfied, the formation of an electrically conductive layer or the like and the performance of the packaging substrate can be improved.

The core distribution layer 24 comprises a core distribution pattern 241, which is an electrically conductive layer electrically connecting the first and second surfaces of the glass substrate via through core vias, and a core insulating layer 223 surrounding the core distribution pattern. The core layer 22 has an electrically conductive layer formed therein in the core vias, which acts as an electrical pathway across the glass substrate 21 and may connect the top and bottom of the glass substrate over a relatively short distance, resulting in faster electrical signal transfer and low loss. The electrically conductive layer may be, for example, but not limited to, a copper plating layer.

The cavity portion 28 is substantially circular, triangular, square, hexagonal, octagonal, cross-shaped, or otherwise non-limiting in shape.

The electronic element 40 may be generally cylindrical, cuboidal, or polygonal in shape.

The cavity portion 28 may comprise a cavity distribution pattern, which is an electrically conductive layer electrically connecting the electronic element 40 and the core distribution layer 24, and an insulating layer surrounding the cavity distribution pattern.

In other embodiments, the cavity portion may be implemented in a form that penetrates the first surface 213 and the second surface 214 of the glass substrate 21. In this case, the cavity portion may be formed according to a process similar to the formation process of the core vias 23 and may differ from the core vias 23 in the area and shape that it penetrates the glass substrate 21.

In such an implementation, an insulating layer may be generated in the cavity portion after it is arranged in the cavity element 40, i.e., an insulating layer may be generated in the cavity portion through the process of generating the core insulating layer 223 described above.

The core distribution pattern 241 may be patterned to be electrically coupled to the cavity element 40.

The cavity element 40 may comprise an active element, such as a transistor, or a passive element, such as a power transfer element, such as a multilayer ceramic capacitor (MLCC).

If an element such as a transistor, which plays a role in converting electrical signals between the motherboard and the semiconductor element portion to an appropriate level, is applied to the cavity element 40, the packaging substrate 20 may be formed in a form in which a transistor or the like is applied in the way of the packaging substrate 20, thereby providing a semiconductor device 100 having improved efficient and higher speed.

In addition, power transfer elements, such as multilayer ceramic capacitors (MLCCs), play an important role in the performance of semiconductor devices. It is common for at least 200 or more power transfer elements, which are passive devices, to be applied to a semiconductor device, and their performance in transferring power is also affected by the characteristics of the electrically conductive layer surrounding the device. In one embodiment, non-circular shaped core via may be applied where a low resistance electrically conductive layer is required, such as in power transfer devices.

On the other hand, a passive element such as a capacitor may be inserted individually and applied to the cavity element 40, or a group of elements comprising a plurality of passive elements in a form embedded between an insulator layer (cavity element insulation layer) may be formed so that the electrodes are exposed and then inserted into the cavity element. The latter option is more workable for packaging substrate fabrication and more favorable for ensuring that the insulating layer is sufficiently and reliably located in the space between complex devices.

The glass substrate 21 plays an intermediate role, an intermediary role, connecting the semiconductor element portion 30 and the motherboard 10 on the upper and lower sides, respectively, and the core via 23 acts as a passageway for transmitting electrical signals therebetween, thereby facilitating smooth signal transmission. For the purpose of distinguishing from the core via of the second zone 222 described later, the core via disposed in the first zone 221 will be referred to as the first zone core via.

The upper layer 26 is located on the above-mentioned first surface 213.

The upper layer 26 may comprise an upper distribution layer 25 and an upper surface contact layer 27 positioned on the upper distribution layer 25, and the uppermost surface of the upper layer 26 may be protected by a cover layer 60 having an opening formed through which the contact electrodes of the semiconductor element may directly contact the upper surface contact layer 27.

The upper distribution layer 25 may comprise an upper insulating layer 253 positioned on the first surface; and an upper distribution pattern 251 embedded in the upper insulating layer 253 as an electrically conductive layer having a predetermined pattern and electrically connecting at least a portion thereof to the core distribution layer 24. The upper distribution layer 25 disposed above and below each other may be connected to each other via blind vias 252.

The upper insulating layer 253 may be applied as an insulator layer to a semiconductor device or packaging substrate, and may be, for example, an epoxy-based resin containing fillers, but is not limited to.

The insulator layer may be formed by forming a coating layer and curing it, or it may be formed by laminating an uncured or semi-cured insulator film to the core layer 22 and curing it. In this case, by applying a pressure-sensitive lamination method or the like, the insulator may be embedded into the space inside the core vias 23 and the process can proceed efficiently.

In some embodiments, the plurality of insulating layers may be stacked and substantially indistinguishable between the insulating layers, and the plurality of insulating layers are collectively referred to as the upper insulating layer. Additionally, the core insulating layer 223 and the upper insulating layer 253 may contain the same insulating material, in which case the boundary between them may be substantially indistinguishable. Alternatively, in other implementations, the boundaries of the insulator layers may be created by setting different pressures and temperatures for curing the multiple insulator layers.

The upper distribution pattern 251 refers to an electrically conductive layer located within the upper insulating layer 253 in a preset shape, which may be formed, for example, in a build-up layer method. Specifically, the upper distribution pattern 251 may be formed by forming an insulator layer, removing an unnecessary portion of the insulator layer, forming an electrically conductive layer by copper plating or the like, optionally removing an unnecessary portion of the electrically conductive layer, forming an insulator layer on top of the electrically conductive layer, removing an unnecessary portion of the insulator layer, forming an electrically conductive layer by plating or the like, and so on, so that the electrically conductive layer is formed in a vertical or horizontal direction in the desired pattern.

Since the upper distribution pattern 251 is located between the core layer 22 and the semiconductor element portion 30, it is formed to comprise a fine pattern in at least a portion thereof so that the transmission of electrical signals to the semiconductor element portion 30 can proceed smoothly and the intended complex pattern can be sufficiently accommodated. In this case, the fine pattern may have a width and spacing of less than 4 µm, 3.5 µm or less, 3 µm or less, 2.5 µm or less, or 2.3 µm or less. The ine pattern may have a width and spacing of 1 µm or more (hereinafter, the description of the fine pattern will be the same).

The upper surface contact layer 27 comprises an upper surface connection pattern 272 electrically connected, at least partially, with the upper distribution pattern 251 and located on the upper insulating layer 253, and an upper surface contact electrode 271 electrically connecting the upper surface connection pattern 272 with the semiconductor element portion 30.

The upper surface connection pattern 272 may be located on a first surface of the upper insulating layer 253, or at least a portion thereof may be exposed and embedded in the upper insulating layer. For example, if the upper surface connection pattern is located on one side of the upper insulating layer, the upper insulating layer may be formed by plating or the like, and if the upper surface connection pattern is embedded with a part of it exposed on the upper insulating layer, it may be that a part of the insulating layer or electrically conductive layer is removed by surface polishing, surface etching, or the like after forming a copper plating layer or the like.

The upper surface connection pattern 272 may comprise at least a portion of a fine pattern, such as the upper distribution pattern 251 described above. The upper surface connection pattern 272 comprising such fine patterns enables a larger number of elements to be electrically connected in a smaller area, allowing for smoother electrical signal connections between devices or to the outside world, and more integrated packaging.

The upper surface contact electrode 271 may be directly connected to the semiconductor element portion 30 by terminals or the like or may be connected via an element connection portion 51 such as a solder ball.

In the case of a half-cavity substrate, the cavity portion 28 may comprise a cavity distribution layer 282 located above and/or below the second zone 222 and electrically connected to the core distribution pattern 241, and an inner space 281 in which the electronic elements 40 are located. The cavity distribution layer 282 may be formed through the second zone core via 232 (see FIG. 3A).

Specifically, the second zone 222 has a thinner thickness of the glass substrate 21 compared to the first zone 221, and the electronic element 40 may be located in the inner space 281 formed due to the difference in thickness. Furthermore, the core vias 23 and the core distribution layer 24 formed on the glass substrate 21 serve as an electrical connection structure connecting the electronic element 40 and the external element.

Furthermore, as described above, a cavity portion in the form of penetrating the first zone 221, i.e., the first surface 213 and the second surface 214 of the glass substrate 21, rather than the second zone 222, may be created, and the electronic element 40 may be arranged in the cavity portion.

The packaging substrate 20 is also connected to a motherboard 10. The motherboard 10 may be electrically connected to the core distribution pattern 241 located on at least a portion of the second surface 214 of the core layer 22 by terminals of the motherboard 10, either directly or via a board connection portion 52 such as a solder ball. In addition, the core distribution pattern 241 in contact with the motherboard 10 may be connected to the motherboard 10 via a lower layer (not shown) located at the bottom of the core layer 22. The element connection portion 51 and the board connection portion 52 are collectively referred to as the connection portion 50.

In one example, no substantially additional substrate other than the glass substrate 21 may be applied to the packaging substrate 20 positioned between the semiconductor element portion 30 and the motherboard 10.

Traditionally, the interposer and organic substrate are laminated together between the element and the motherboard. This multi-step application is understood to be necessary for at least two reasons: one is that there are scale issues with directly bonding the fine pattern of the element to the motherboard, and the other is that wiring damage can occur during the bonding process or during the driving of the semiconductor device due to differences in thermal expansion coefficients. The embodiment solves these problems by applying a glass substrate having a coefficient of thermal expansion similar to that of a semiconductor device and forming a fine pattern on the first surface of the glass substrate and an upper layer thereof having a scale fine enough for mounting the device.

In the following, a method for manufacturing a packaging substrate according to an embodiment of the present invention will be described.

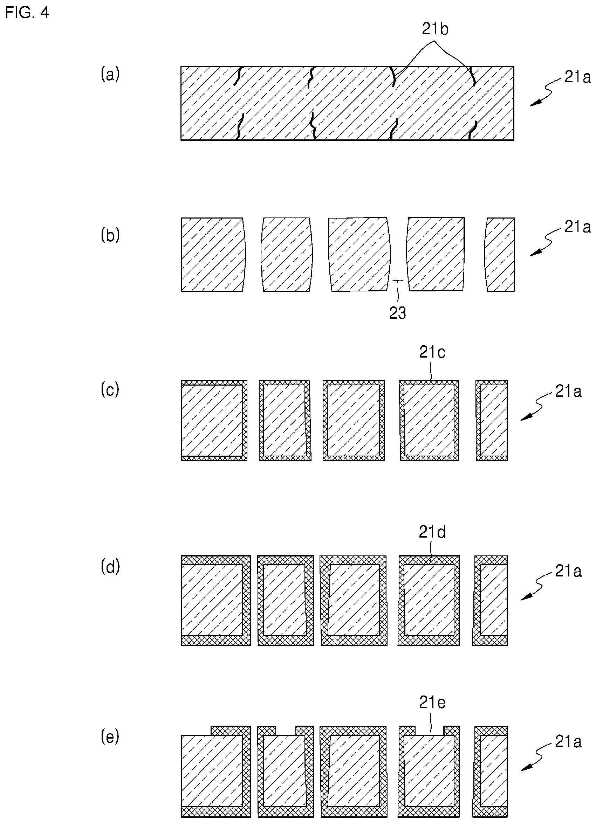

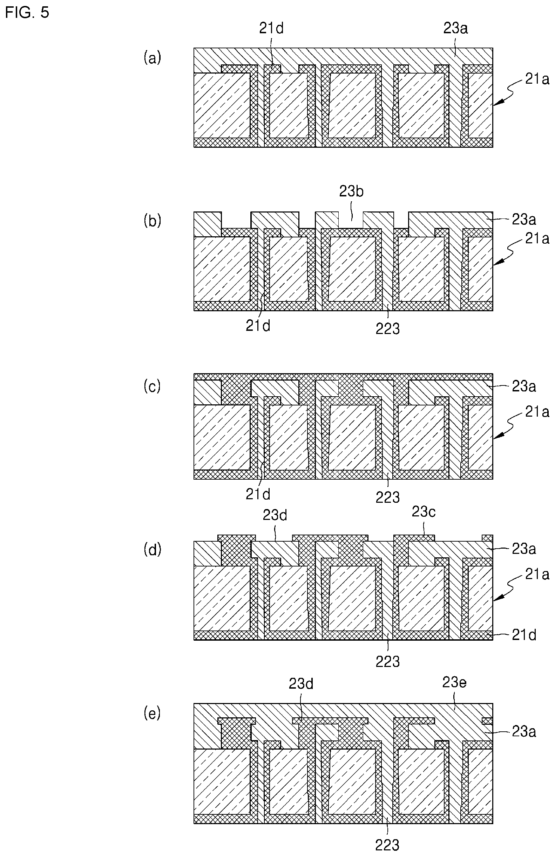

FIGS. 4 and 5 are cross-sectional flowcharts illustrating a process for creating a core distribution layer during manufacturing of a packaging substrate, according to an embodiment.

First, a glass substrate 21a having a flat first and second surface is prepared, as shown in (a) of FIG. 4, and a defect (groove, 21b) is formed on the glass surface at a predetermined position for the formation of a core via. The glass substrate may be a glass substrate applied to a substrate of an electronic device or the like, and for example, an alkali-free glass substrate or the like may be applied but is not limited thereto. As a commercially available product, a product manufactured by a manufacturer such as Corning, Schott, AGC, etc. may be applied. The formation of the defects (grooves) can be accomplished by mechanical etching, laser irradiation, or the like.

As shown in (b) of FIG. 4, the glass substrate 21a on which the defect (groove, 21b) is formed is subjected to an etching operation to form the core vias 23 through a physical or chemical etching process. During the etching process, the glass substrate forms vias in the defect areas, and at the same time, the surface of the glass substrate 21a may be etched. A masking film or the like may be applied to prevent such etching of the glass surface, but in consideration of the cumbersome process of applying and removing the masking film, the defective glass substrate itself may be etched, and in this case, the thickness of the glass substrate having the core vias may be somewhat thinner than the thickness of the initial glass substrate.

Then, the core layer preparation operation may be performed by forming an electrically conductive layer 21d on the glass substrate as shown in (c) and (d) of FIG. 4. The electrically conductive layer may be a metal layer comprising, but not limited to, copper metal.

The surface of the glass (comprising the surface of the glass substrate and the surface of the core via) and the surface of the copper metal may have different properties, which may result in poor adhesion. In an embodiment, the adhesion between the glass surface and the metal can be improved by two methods: a dry method and a wet method.

The dry method is a method of applying sputtering, that is, metal sputtering, to form a seed layer 21c on the surface of the glass and the inner diameter of the core via. In the formation of the seed layer, dissimilar metals such as titanium, chromium, nickel, and the like may be sputtered together with copper, and in this case, glass-to-metal adhesion may be improved by an anchor effect in which the surface morphology of the glass and the metal particles interact.

The wet method is a primer treatment method in which a primer layer 21c is formed by pretreatment with a compound having functional groups such as amines. Depending on the degree of adhesion desired, pretreatment with a silane coupling agent may be followed by primer treatment with a compound or particle having an amine functional group. As mentioned above, the support substrate of the embodiment needs to be of high enough performance to form a fine pattern, which should be maintained after the primer treatment. Therefore, if such primer comprises nanoparticles, it is preferred that nanoparticles having an average diameter of 150 nm or less are applied, for example, particles having amine functional groups. The primer layer may be formed by applying a bonding force improver, for example, such as the CZ series of MEC.

The seed layer/primer layer 21c may optionally form the electrically conductive layer with or without removing the portion where the formation of the electrically conductive layer is unnecessary. Furthermore, the seed layer/primer layer 21c may be optionally activated or deactivated for metal plating with or without removing the portion where the formation of the electrically conductive layer is necessary or unnecessary to proceed with the subsequent process. For example, the activation or deactivation treatment may be subjected to light irradiation treatment such as a laser of a certain wavelength, chemical treatment, or the like. The formation of the metal layer may include, but is not limited to, copper plating methods applied in the manufacture of semiconductor devices.

As shown in (e) of FIG. 4, a portion of the core distribution layer may be removed if it is unnecessary, and after the seed layer is partially removed or inactivated, metal plating may be performed to form an electrically conductive layer in a predetermined pattern to form the etched layer 21e of the core distribution layer.

FIG. 5 illustrates manufacturing operations to form an insulating layer and a top layer pattern, according to one embodiment.

As shown in (a) of FIG. 5, the core via may be subjected to an insulating layer formation operation in which the void space is filled with an insulating layer after the formation of the core distribution layer, which is an electrically conductive layer. In this case, the insulating layer applied may be made in the form of a film, for example, by pressure sensitive lamination of the insulating layer in the form of a film. By performing such pressure-sensitive lamination, the insulating layer can be sufficiently impregnated into the void space inside the core vias to form a core insulating layer without void formation.

Operations (b) through (e) of FIG. 5 illustrate the upper layer manufacturing operations.

The operation of manufacturing the upper layer is to form an upper layer comprising an upper insulating layer and an upper distribution pattern on the core layer. The upper insulating layer may be formed by coating a resin composition forming the insulating layer 23a or by laminating an insulating film, and a simple method of laminating an insulating film is preferred. The lamination of the insulating film may be carried out by laminating the insulating film and curing it, in which case, by applying a pressure sensitive lamination method, the insulating resin may be sufficiently impregnated even to a layer in which an electrically conductive layer is not formed inside the core via. The upper insulating layer is also applied in direct contact with the glass substrate, at least in part, and thus has sufficient adhesion. Specifically, the glass substrate and the upper insulating layer are preferably characterized by an adhesion test value of 4B or more according to ASTM D3359.

The upper distribution pattern may be formed by repeating the process of forming the insulating layer 23a, forming the electrically conductive layer 23c in a predetermined pattern, and etching off the unnecessary parts to form the etched layer 23d of the electrically conductive layer, or, in the case of the electrically conductive layers that are formed adjacent to the insulating layer, forming a blind vias 23b on the insulating layer and then proceeding with the plating process. Dry etching methods such as laser etching, plasma etching, and the like, or wet etching methods using a masking layer and an etching solution, can be applied to form the blind vias.

Then, although not shown, a top surface contact layer and a cover layer may be formed.

The upper surface connection pattern and the upper surface contact electrode may also be formed by a process similar to the formation of the upper layer. Specifically, it may be formed by forming an etched layer of an insulating layer on the insulating layer 23e, forming an electrically conductive layer thereon, and then forming an etched layer of the electrically conductive layer, and so on, but it may also be applied by selectively forming only the electrically conductive layer without applying the method of etching. The cover layer may be formed such that an opening (not shown) is formed at a position corresponding to the top surface contact electrode so that the top surface contact electrode is exposed and can be directly connected to an electrical connection or a terminal of the element.

Once the upper layer has been created, the lower layer can be processed by forming the bottom contact layer and cover layer. The lower layer and/or the bottom contact layer, and optionally the cover layer (not shown), may be formed in a similar manner to the operations for forming the upper surface contact layer and cover layer described above.

As described above, an insulation layer may be formed on the cavity portion by laminating an insulating film [e.g., Ajinomoto Build-up Film (ABF)], and in this case, an undulation phenomenon may occur. In particular, the cavity portion in which the cavity element is embedded may be subject to undulation due to gaps between the elements and/or gaps between the cavity portion and the element. If the undulation phenomenon becomes severe, leakage current may occur in the cavity, which may be fatal to active elements that are vulnerable to leakage current.

In addition, when an electronic element is disposed of in a cavity having an electrode formed on its inner surface, or when a plurality of electronic elements are disposed in the cavity, defects may occur due to inaccuracies in the placement position or unintentional warping of the substrate during the manufacturing process. For example, due to the nature of the elements that are adjacent to each other, and the electrodes exposed between the elements and/or the elements and the electrodes, short circuits or the like may occur due to contact with each other, which may cause defects in the packaging substrate.

Accordingly, the present invention proposes an embodiment that substantially prevents an undulation phenomenon from occurring in a cavity portion in which electronic elements are embedded, thereby achieving purposes such as improving the effectiveness of preventing leakage current generation and reducing defects in a packaging substrate. For example, in accordance with the present invention, it is proposed to perform the process of forming an insulating layer over a plurality of times instead of once, to utilize a cavity module in which two or more electronic elements are modularized.

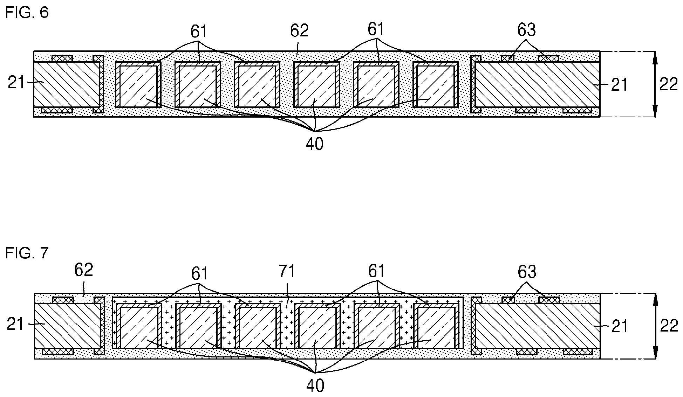

FIG. 6 is an example of a cross-sectional view of a core layer of a packaging substrate created in accordance with an embodiment useful for understanding the present invention. The packaging substrate of FIG. 6 is a conceptually simplified drawing to illustrate a core layer generated in accordance with an embodiment useful for understanding the present invention and may be subject to the teachings described with reference to FIGS. 1 through 3.

For example, referring to FIG. 6, a glass substrate 21 having first and second surfaces facing each other and a core layer 22 comprising core vias through the glass substrate 21 may be formed. An electrode 63 may be formed on the surface of the glass substrate 21. Further, for example, a cavity portion 28 according to FIG. 6 may be formed by penetrating both the first surface and second surface of the glass substrate 21, and an electronic element 40 may be disposed of inside the cavity portion 28.

As described above, the electronic element 40 may comprise both passive or active elements. The cavity portion 28 may be formed simultaneously with the core via in the same forming operation as the core via, or it may be formed independently after the core via is formed or before the core via is formed.

Furthermore, the electronic element 40 disposed of inside the cavity portion 28 may be wrapped with the first insulating layer 61 on all or all sides except for one side. That is, for example, in the cavity portion 28, the electronic element 40 is disposed, but the first insulating layer may be formed on all or all sides except for one side of the electronic element 40. The electronic element and the first insulating layer surrounding the electronic element are referred to as a cavity module. The cavity module may comprise: i) two or more electronic elements arranged therein; and ii) a first insulating layer surrounding each of the electronic elements.

For example, if the electronic element 40 is in the form of a hexahedron, all five sides of the electronic element 40 except for one side (e.g., the bottom side) may be wrapped with the first insulating layer 61. Alternatively, the edges of the top surface of the electronic element 40 may be wrapped with the first insulating layer 61, i.e., the first insulating layer 61 may be formed on the edges of the top surface of the electronic element 40.

For example, if the electronic element 40 is in the form of a column, the sides and/or the top surface of the electronic element 40, except for the bottom surface, may be wrapped with the first insulating layer 61. Alternatively, the edges of the top surface of the electronic element 40 may be wrapped with the first insulating layer 61, i.e., the first insulating layer 61 may be formed at the edges of the top surface of the electronic element 40.

For example, one or more connection electrodes may be formed in the direction of the bottom surface of the electronic element 40. Alternatively, for example, all five sides of the electronic element 40 except for the top surface may be wrapped by the first insulating layer 61. Alternatively, for example, the edges of the bottom surface of the electronic element 40 may be wrapped by the first insulating layer 61, i.e., the first insulating layer 61 may be formed at an edge of the bottom surface of the electronic element 40. In this case, for example, one or more connection electrodes may be formed in the direction of the top surface of the electronic element 40.

The first insulating layer 61 is formed on the entire surface or the entire surface except for one side of the electronic element 40, so that shorts caused by contact between electronic elements disposed side by side can be prevented. Furthermore, shorts that may occur unintentionally during the manufacturing process of forming an electrically conductive layer on the side of the cavity portion 28 may be prevented by the first insulating layer 61 formed on all or all of the surfaces except for one side of the electronic element 40.

Furthermore, the core layer 22 according to FIG. 6 may comprise a second insulating layer 62 laminated on the first surface and the second surface. The remaining portion of the cavity portion 28 according to FIG. 6 except for the electronic element 40 and the first insulating layer 61 may be filled with the second insulating layer 62. In other words, after placing the cavity module in the cavity portion 28, there may be a remaining space inside the cavity portion, and the second insulating layer 62 may be formed therein. For example, the core layer 22 according to FIG. 6 may comprise the second insulating layer 62 embedded in the remaining portion of the cavity portion 28 other than the cavity module. For example, the second insulating layer 62 may be laminated and cured to a top (e.g., first surface) of the glass core 21 and a bottom (e.g., second surface) of the glass core 21, thereby creating a second insulating layer.

A connection electrode may be connected to the electronic element 40.

The connection electrode may be disposed on an exposed surface on which the first insulating layer 61 of the electronic element 40 is not disposed.

A connection electrode may be disposed through the first insulating layer 61 of the electronic element 40. The connection electrodes may be in the form of blind vias.

The first insulating layer may further comprise first insulating layer vias (not shown) penetrating the first insulating layer. The first insulating layer via may be partially or wholly filled with electrode material therein.

The first insulating layer via may be in contact with the electronic element 40 at one end, and the other end of the first insulating layer via may be exposed outside of the cavity portion 28.

The first insulating layer via may be arranged in such a way that it penetrates the cavity portion 28 up and down without directly contacting the electronic element 40.

The electrode material may be an electrically conductive material, exemplary an electrically conductive metal. Specifically, copper, copper alloys, silver, and the like may be applied, but are not limited to.

The same material may be used as the first insulating layer 61 and the second insulating layer 62, or different materials may be used. In the latter case, materials with different dielectric constants may be applied.

For example, the first insulating layer 61 and the second insulating layer 62 may have different dielectric constants. For example, the first insulating layer 61 may have the same or a lower dielectric constant than the second insulating layer 62. This has the advantage of substantially suppressing the occurrence of undulation phenomena in the cavity, while providing sufficient insulation effect for each electronic element.

The first insulating layer 61 and the second insulating layer 62 may comprise an insulating material, respectively.

For example, the insulating material may be a polymer resin, a mixture of a polymer resin and a filler (inorganic particles, organic particles, organic-inorganic composite particles, etc), inorganic deposited layer and the like.

For example, the polymer resin may be an acrylic resin, an epoxy resin, a modified resin thereof, or the like, and a material applicable to the electronic device for the purpose of molding or the like may be applied. For example, liquid crystal polymer (LCP) and the like may be applied.

Exemplarily, the mixture may be a mixture of an acrylic resin and a filler, a mixture of an acrylic resin and an epoxy resin and a filler, a mixture of an epoxy resin and a filler, and the like. The filler may be an inorganic particle, exemplary a silica particle. As commercially available products, Ajinomoto Build-up Film (ABF), Epoxy Molding Compound (EMC), Modified Polyimide (MPI), and the like may be applied, but are not limited to.

The inorganic deposition may comprise, but is not limited to, silicon oxide deposited layers, silicon nitride deposited layers, and the like.

The first insulating layer 61 and the second insulating layer 62 may contain materials having the same or different Coefficients of Thermal Expansion (CTE). Preferably, a material having a small difference between the coefficient of thermal expansion of the first insulating layer 61 and the coefficient of thermal expansion of the second insulating layer 62 may be applied.

The difference between the coefficient of thermal expansion of the material of the first insulating layer and the material of the second insulating layer may be 2 ppm/°C or less, 1.5 ppm/°C or less, 1 ppm/°C or less, or 0.5 ppm/°C or less. The difference in coefficient of thermal expansion may be 0 ppm/°C or more, 0.1 ppm/°C or more, or 0.2 ppm/°C or more.

The coefficient of thermal expansion of the first insulating layer 61 may be greater than or equal to 8 ppm/°C, greater than or equal to 10 ppm/°C, greater than or equal to 12 ppm/°C, or greater than or equal to 14 ppm/°C. The coefficient of thermal expansion may be 20 ppm/°C or less, 18 ppm/°C or less, or 17 ppm/°C or less.

The coefficient of thermal expansion of the second insulating layer 62 may be greater than or equal to 8 ppm/°C, greater than or equal to 10 ppm/°C, or greater than or equal to 12 ppm/°C. The coefficient of thermal expansion may be 20 ppm/°C or less, 18 ppm/°C or less, 16 ppm/°C or less, or 14 ppm/°C or less.

The first insulating layer 61 and the second insulating layer 62 may contain materials having different dielectric constants. Advantageously, the material of the insulating layer may be selected and applied so that the dielectric constant of the first insulating layer 61 is lower than the dielectric constant of the second insulating layer 62.

The first insulating layer 61 and the second insulating layer 62 may contain a material having a difference in specific relative dielectric constant Dk at a high frequency of 5.8 GHz. For example, the difference between the Dk of the first insulating layer 61 and the Dk of the second insulating layer 62 may be 0.1 or more. The difference in Dk may be 0.1 or more, 0.13 or more, 0.16 or more, or 0.2 or more. The difference in Dk may be 1 or less, 0.8 or less, 0.6 or less, 0.5 or less, 0.4 or less, 0.3 or less, or 0.25 or less.

The Dk of the first insulating layer 61 may be 2.3 or more, 2.5 or more, 2.7 or more, or 2.9 or more. The Dk may be 3.4 or less, 3.2 or less, or 3.1 or less.

The Dk of the second insulating layer 62 may be greater than or equal to 3.0, greater than or equal to 3.1, or greater than or equal to 3.2. The Dk may be 3.6 or less, 3.5 or less, or 3.4 or less.

The Dk of the first insulating layer 61 may be less than the Dk of the second insulating layer 62.

The first insulating layer 61 and the second insulating layer 62 may contain materials having the same or different dielectric loss factor Df. Preferably, a material having a difference between the Df of the first insulating layer 61 and the Df of the second insulating layer 62 of 0.0001 or more may be applied. The difference in Df may be greater than or equal to 0.0001, greater than or equal to 0.0005, or greater than or equal to 0.001. The difference in Df may be 0.02 or less.

The Df of the first insulating layer 61 may be 0.004 or less, 0.0038 or less, or 0.0036 or less. The Df may be 0.001 or greater, 0.0015 or greater, 0.0018 or greater, or 0.002 or greater.

The Df of the second insulating layer 62 may be 0.005 or less, 0.0048 or less, or 0.0046 or less. The Df may be greater than or equal to 0.003, greater than or equal to 0.0032, or greater than or equal to 0.0034.

The Df of the first insulating layer 61 may be smaller than the Df of the second insulating layer 62.

For example, the second isolating layer 62 may be ABF and the first insulating layer 61 may be LCP. For example, the second insulating layer 62 may be EMC and the first insulating layer 61 may be LCP. For example, the second insulating layer 62 and the first insulating layer 61 may be ABF with different dielectric constants.

The formation of the first insulating layer 61 may be accomplished by forming an insulating layer on the surface of the electronic element 40 using, for example, a varnish-type method, a selective lamination method, a deposition method, or the like.

The second insulating layer 62 may be formed by any conventional method for forming an insulating layer in a cavity of a packaging substrate, or the method applied to the formation of the first insulating layer 61 may be applied.

FIG. 7 is an example of a cross-sectional structure of a core layer of a packaging substrate created according to an embodiment of the present invention. The packaging substrate of FIG. 7 is a conceptually simplified drawing to illustrate a core layer created in accordance with an embodiment and may be described with reference to FIGS. 1 through 3.

The packaging substrate comprises a glass core 21 having first and second surfaces facing each other and a core layer 22 comprising core vias through the glass core 21 may be formed. An electrode 63 may be formed on the surface of the glass core 21. Further, for example, a cavity portion 28 is formed through both the first and second surfaces of the glass core 21, and a cavity module is disposed inside the cavity portion 28, i.e., a cavity module may be disposed in the cavity portion.

As described above, the electronic element 40 may comprise a passive element, an active element, or both. The cavity portion 28 may be formed simultaneously with the core via in the same forming operation as the core via or may be formed independently after the core via is formed or before the core via is formed.

Further, the cavity module disposed inside the cavity portion 28 according to FIG. 7 comprises: i) a plurality of electronic elements arranged therein, ii) a first insulating layer 61 covering each of the electronic elements 40, and iii) a third insulating layer 71 comprising a molding material and arranged to wrap the electronic elements 40. In other words, in the cavity portion according to FIG. 7, where the electronic elements 40 are disposed, the first insulating layer 61 is formed on all or all but one side of the electronic elements 40, and the third insulating layer 71 comprises a molding material and be arranged to cover the electronic elements on which the first insulating layer is formed.

The electronic element, the first insulating layer surrounding the electronic element, and the third insulating layer surrounding the electronic element on which the first insulating layer is formed are collectively referred to as a cavity module. That is, the cavity module may comprise: i) two or more electronic elements arranged, ii) a first insulating layer surrounding each of the electronic elements, and iii) a third insulating layer 71 comprising a molding material and arranged such that the molding material surrounds the electronic elements.

The third insulating layer is cavity-modularized by fixing and modulating the relative positions of the electronic elements wrapped by the first insulating layer in an arranged state.

The description of the electronic element 40, the first insulating layer 61, the second insulating layer 62, and the like is redundant with the above description, and a detailed description is omitted. The molding material of the third insulating layer 71 will be described later.

The remaining portion of the cavity portion 28 according to FIG. 7 except for the electronic element 40, the first insulating layer 61 and the third insulating layer 71 is filled with the second insulating layer 62. In other words, after placing the cavity module in the cavity portion 28, there may be a remaining space inside the cavity portion, and the second insulating layer 62 is formed with an insulating material. For example, the core layer 22 according to FIG. 7 may be impregnated with an insulating material in the remaining portion of the cavity portion 28 except for the cavity module and cured to form the second insulating layer 62. For example, the second insulating layer 62 may be laminated and cured on the upper (e.g., first) face of the glass core 21 and the lower (e.g., second) face of the glass core 21, thereby creating the second insulating layer.

When there are two or more electronic elements included in the cavity module, the spacing between the neighboring electronic elements 40 may be 30 µm or more, 50 µm or more, or 80 µm or more. Further, the spacing may be 300 µm or less, 250 µm or less, or 200 µm or less. By having such spacing, interference between the electronic elements in the cavity may be minimized and space utilization may be increased.

The thickness of the cavity module may be 335 µm or more, 370 µm or more, or 400 µm or more. The thickness may also be 1,000 µm or less, 900 µm or less, 800 µm or less, 700 µm or less, 665 µm or less, 620 µm or less, or 600 µm or less. The thickness may be substantially the same as the thickness of the glass substrate 21, or the thickness difference may be more than 1 µm or more and less than or equal to 30 µm.

The molding material of the third insulating layer 71 may comprise a material capable of properly securing the element while preventing electrical shortage. The molding material may comprise one or more selected from the group consisting of epoxy-based resins, polyimide-based resins, polyurethane-based resins, polyester-based resins, acrylate-based resins, and polyamide-based resins. Exemplarily, the molding material may comprise an epoxy molding compound (EMC), a fiberglass reinforced epoxy (FR-4), and the like. The molding material may comprise other additives, phenolic resins, carbon black, flame retardants, fillers, and the like. The filler that may be contained in the molding material may be a particle-shaped filler, and the particle size of the filler may be 1 µm to 20 µm, 2 µm to 15 µm, etc.

A connection electrode may be connected to the electronic element 40.

The connection electrode may be disposed on an exposed surface on which the first insulating layer 61 of the electronic element 40 is not disposed. The connection electrode may be disposed on the exposed surface where the first insulating layer 61 and the third insulating layer 71 of the electronic element 40 are not disposed.

A connection electrode may be disposed through the first insulating layer 61 of the electronic element 40. A connection electrode may be disposed through the first insulating layer 61 and the third insulating layer 71 of the electronic element 40. The connection electrodes may be in the form of blind vias. Specifically, in the electronic element 40, a portion of each of the first insulating layer 61 and the third insulating layer 71 may be removed in the form of a via or the like, and an electrically conductive material may be incorporated therein to become a connection electrode.

The first insulating layer may further comprise first insulating layer vias (not shown) penetrating the first insulating layer. The first insulating layer via may be partially or wholly filled with electrode material therein.

The third insulating layer may further comprise third insulating layer via (not shown) penetrating the third insulating layer. The third insulating layer via may be partially or wholly filled with electrode material therein.

The first insulating layer via may be in contact with the electronic element 40 at one end, and the other end of the first insulating layer via may be exposed outside the first insulating layer.

The first insulating layer via may have one end abutting the electronic element 40, the other end of the first insulating layer via may abut the other end of the third insulating layer via, and the other end of the third insulating layer via may be exposed outside of the cavity portion 28.

The third insulating layer via may be arranged in such a way that it penetrates up and down the cavity portion 28 without directly contacting the electronic element 40.

The electrode material may be an electrically conductive material, exemplary an electrically conductive metal. Specifically, copper, copper alloys, silver, and the like may be applied, but are not limited to.

The same material may be applied as the first insulating layer 61, the second insulating layer 62, and the third insulating layer 71. Alternatively, different materials may be used, which is preferred. In the latter case, materials having different dielectric constants may be applied.

The first insulating layer 61, the second insulating layer 62, and the third insulating layer 71 may have different dielectric constants. For example, the first insulating layer 61 may have the same or lower dielectric constant than the second insulating layer 62 and the third insulating layer 71. This has the advantage of substantially suppressing the occurrence of undulation phenomena in the cavity, while providing sufficient insulation effect for each electronic element.

The first insulating layer 61 and the second insulating layer 62 may each comprise an insulating material (coating material), and the third insulating layer 71 may comprise a molding material.

The insulating material and the molding material may each be a polymeric resin, a mixture of a polymeric resin and a filler (inorganic particles, organic particles, organic-inorganic composite particles, etc.), inorganic deposited layer and the like.

The polymer resin may be an acrylic resin, an epoxy resin, a modified resin thereof, or the like, and a material applicable to the electronic device for the purpose of molding or the like may be applied. For example, liquid crystal polymer (LCP) and the like may be applied.

The mixture may be a mixture of acrylic resin and filler, a mixture of acrylic resin and epoxy resin and filler, a mixture of epoxy resin and filler, and the like. The filler may be an inorganic particle, exemplary a silica particle. As commercially available products, Ajinomoto Build-up Film (ABF), Epoxy Molding Compound (EMC), Modified Polyimide (MPI), and the like may be applied, but are not limited to.

The inorganic deposition may comprise, but is not limited to, silicon oxide deposited layers, silicon nitride deposited layers, and the like.

For example, the first insulating layer 61 may comprise an inorganic deposited layer, a liquid crystal polymer (LCP), an epoxy molding compound (EMC), an Ajinomoto build-up film (ABF), or a modified polyimide (MPI).

For example, the second insulating layer 62 may comprise, but is not limited to, organic or inorganic composite materials, specifically Ajinomoto Build-up Film (ABF).

For example, the third insulating layer 71 may comprise a molding material that is an EMC (Epoxy Molding Compound), ABF (Ajinomoto Build-up Film), or MPI (Modified Polyimide).

The ABF of the second insulating layer and the ABF of the third insulating layer may have different properties. Specifically, even if the material is referred to as ABF, properties such as the coefficient of thermal expansion and dielectric constant may vary somewhat depending on the specific type of resin applied, the content of inorganic particles applied, etc.

The first insulating layer 61, the second insulating layer 62, and the third insulating layer 71 may contain materials having the same or different coefficients of thermal expansion (CTE). Preferably, a material having a small difference in the coefficient of thermal expansion of the first insulating layer 61, the coefficient of thermal expansion of the second insulating layer 62, and the coefficient of thermal expansion of the third insulating layer 71 may be applied.

The difference in the coefficient of thermal expansion of the material of the first insulating layer and the material of the third insulating layer may be 2 ppm/°C or less, 1.5 ppm/°C or less, 1 ppm/°C or less, or 0.5 ppm/°C or less. The difference in coefficient of thermal expansion may be 0 ppm/°C or more, 0.1 ppm/°C or more, or 0.2 ppm/°C or more.

The coefficient of thermal expansion of the first insulating layer 61 may be greater than or equal to 8 ppm/°C, greater than or equal to 10 ppm/°C, greater than or equal to 12 ppm/°C, or greater than or equal to 14 ppm/°C. The coefficient of thermal expansion may be 20 ppm/°C or less, 18 ppm/°C or less, or 17 ppm/°C or less.

The coefficient of thermal expansion of the second insulating layer 62 may be greater than or equal to 8 ppm/°C, greater than or equal to 10 ppm/°C, or greater than or equal to 12 ppm/°C. The coefficient of thermal expansion may be 20 ppm/°C or less, 18 ppm/°C or less, 16 ppm/°C or less, or 14 ppm/°C or less.

The coefficient of thermal expansion of the third insulating layer 71 may be greater than or equal to 8 ppm/°C, greater than or equal to 10 ppm/°C, or greater than or equal to 12 ppm/°C. The coefficient of thermal expansion may be 20 ppm/°C or less, 18 ppm/°C or less, 16 ppm/°C or less, or 14 ppm/°C or less.

The first insulating layer 61, the second insulating layer 62, and the third insulating layer 71 may be applied with materials having different dielectric constants. Advantageously, the materials of the insulating layers may be selected and applied so that the dielectric constant of the first insulating layer 61 is lower than the dielectric constant of the second insulating layer 62 and the dielectric constant of the third insulating layer 71. Also, the material of the insulating layer may be selected and applied so that the dielectric constant of the second insulating layer 62 is lower than the dielectric constant of the third insulating layer 71.

The first insulating layer 61, the second insulating layer 62, and the third insulating layer 71 may contain a material having a difference in relative dielectric constant Dk at a high frequency of 5.8 GHz. For example, the difference between the Dk of the first insulating layer 61 and the Dk of the third insulating layer 71 may be 0.1 or more. The difference in Dk may be 0.1 or more, 0.13 or more, 0.16 or more, or 0.2 or more. The difference in Dk may be 1 or less, 0.8 or less, 0.6 or less, 0.5 or less, 0.4 or less, 0.3 or less, or 0.25 or less.

The Dk of the first insulating layer 61 may be 2.3 or more, 2.5 or more, 2.7 or more, or 2.9 or more. The Dk may be 3.4 or less, 3.2 or less, or 3.1 or less.

The Dk of the second insulating layer 62 may be greater than or equal to 3.0, greater than or equal to 3.1, or greater than or equal to 3.2. The Dk may be 3.6 or less, 3.5 or less, or 3.4 or less.

The Dk of the third insulating layer 71 may be greater than or equal to 3.0, greater than or equal to 3.1, or greater than or equal to 3.2. The Dk may be 3.6 or less, 3.5 or less, or 3.4 or less.

The Dk of the first insulating layer 61 may be less than the Dk of the third insulating layer 71.

The first insulating layer 61, the second insulating layer 62, and the third insulating layer 71 may contain materials having the same or different dielectric constant Df. Preferably, a material having a difference between the Df of the first insulating layer 61 and the third insulating layer 71 of 0.0001 or more may be applied. The difference in Df may be greater than or equal to 0.0001, greater than or equal to 0.0005, or greater than or equal to 0.001. The difference in Df may be 0.02 or less.

The Df of the first insulating layer 61 may be 0.004 or less, 0.0038 or less, or 0.0036 or less. The Df may be 0.001 or greater, 0.0015 or greater, 0.0018 or greater, or 0.002 or greater.

The Df of the second insulating layer 62 may be 0.005 or less, 0.0048 or less, or 0.0046 or less. The Df may be greater than or equal to 0.003, greater than or equal to 0.0032, or greater than or equal to 0.0034.

The Df of the third insulating layer 71 may be 0.005 or less, 0.0048 or less, or 0.0046 or less. The Df may be greater than or equal to 0.003, greater than or equal to 0.0032, or greater than or equal to 0.0034.

The Df of the first insulating layer 61 may be less than the Df of the third insulating layer 71.

The Df of the first insulating layer 61 may be less than the Df of the second insulating layer 62 and the Df of the third insulating layer 71.

The third insulating layer 71 may have a 25 °C bending strength of 5 kg/mm^2 or more, 7 kg/mm^2 or more, or 10 kg/mm^2 or more. Alternatively, the bending strength may be 25 kg/mm^2 or less, 20 kg/mm^2 or less, or 18 kg/mm^2 or less.

The third insulating layer 71 may have a 25 °C bending modulus of at least 1,200 kg/mm^2, 1,300 kg/mm^2, or at least 1,400 kg/mm^2. The bending modulus may be 2,500 kg/mm^2 or less, 2,300 kg/mm^2 or less, or 2,100 kg/mm^2 or less.

The third insulating layer 71 may have a 23 °C elongation at break of 0.3% to 7%.

The third insulating layer 71 may have a thermal conductivity of 0.3 W/m·K or more, 0.5 W/m·K or more, 0.7 W/m·K or more. Further, the thermal conductivity may be 2.3 W/m·K or less, 2.0 W/m·K or less, or 1.8 W/m·K or less.

Since the third insulating layer 71 has these properties, the electronic element may be reliably fixed and insulated.

For example, the third insulating layer 71 may contain EMC, the second insulating layer 62 may contain ABF, and the first insulating layer 61 may contain LCP. For example, the third insulating layer 71 may contain EMC, the second insulating layer 62 may contain EMC, and the first insulating layer 61 may contain LCP. The EMC of the third insulating layer and the EMC of the second insulating layer may have different dielectric constants. For example, the third insulating layer 71 may contain an ABF, the second insulating layer 62 may contain an ABF, and the first insulating layer 61 may contain an LCP. The ABF of the third insulating layer and the ABF of the second insulating layer may have different dielectric constants. For example, the third insulating layer 71, the second insulating layer 62, and the first insulating layer 61 may contain an EMC with different dielectric constants, respectively. For example, the third insulating layer 71, the second insulating layer 62, and the first insulating layer 61 may contain ABFs having different dielectric constants, respectively.

In terms of controlling the dielectric constant, it is preferred that the third insulating layer 71 may contain EMC, the second insulating layer 62 may contain ABF, and the first insulating layer 61 may contain LCP.

The formation of the first insulating layer 61 may be accomplished by forming an insulating layer on the surface of the electronic element 40 using, for example, a varnish-type method, a selective lamination method, a deposition method, or the like.

The second insulating layer 62 may be formed by any conventional method of forming an insulating layer in a cavity of a packaging substrate, or the method applied to the formation of the first insulating layer 61 may be applied.

The third insulating layer 71 may be applied to form a molded part, for example, by placing a mold on the electronic elements arranged above and having the first insulating layer formed, injecting a molding material into the mold, and then curing the molding material.

A manufacturing method is proposed for creating a packaging substrate according to the embodiments illustrated in FIGS. 6 and 7.

The packaging substrate according to FIG. 6 may be manufactured by providing a glass core 21 having a cavity portion 28 arranged therein and an electronic element 40 having a first insulating layer 61 formed thereon, arranging the electronic element 40 in the cavity portion 28, and laminating a second insulating layer 62 on the glass substrate.

The packaging substrate according to FIG. 7 may be manufactured by preparing a glass core 21 having a cavity portion 28 and a cavity module, arranging the cavity module in the cavity portion 28, and laminating a second insulating layer 62 on the glass substrate.

The present invention proposes embodiments that generate a packaging substrate according to the following embodiments.

In one embodiment, electronic elements may be selected and placed in a mold; and each of the electronic elements may then be coated (or sputtered) with a first insulating layer. Then, if necessary, at least a portion of the first insulating layer coated on a particular side (e.g., a top side or a bottom side) of the electronic elements may be removed to form an electrode or the like. Then, if necessary, a molding material may be placed in the mold in which the electronic elements are disposed of and cured to provide a cavity module. Optionally, the cavity electrode may be formed by removing a part of the molding material.

The cavity module may be disposed on a glass substrate having a cavity, and a second insulating layer may be provided thereon. The second insulating layer may be formed by forming a Re-Distribution Layer (RDL).

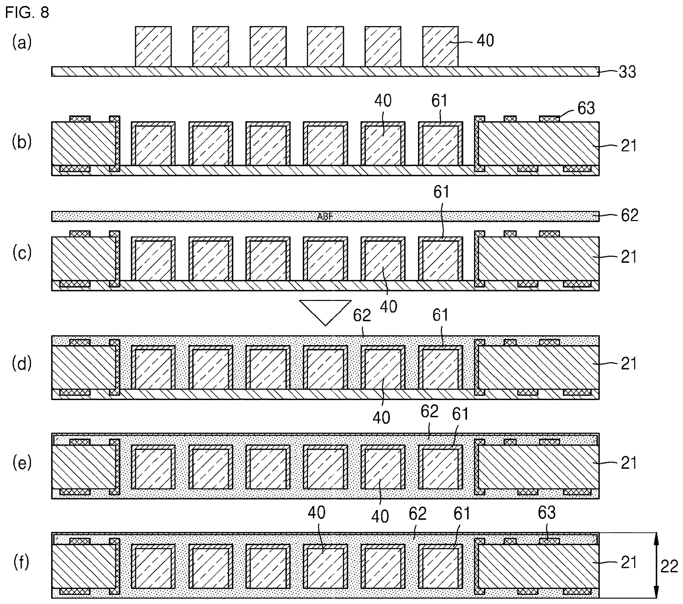

FIG. 8 is a cross-sectional flowchart illustrating a method of manufacturing a packaging substrate according to an embodiment useful for understanding the present invention.

Referring to FIG. 8, the operations for forming the first and second insulating layers on the packaging substrate are more specifically as follows.

For example, as shown in (a) of FIG. 8, an electronic element 40 may be attached to an adhesive film.

Subsequently, as shown in (b) of FIG. 8, the first insulating layer 61 may be formed on some surfaces other than the top or bottom surfaces of the electronic element 40. For example, the first insulating layer 61 may be formed on some surfaces other than the top surface or bottom surface of the electronic element 40 in the cavity portion 28 by performing a sputter, coating, or molding process on the electronic element 40. For example, one or more connection electrodes may be formed in the direction of the bottom surface of the electronic element 40. For example, one or more connection electrodes may be formed in a top surface direction or a bottom surface direction of the electronic element 40. Here, the glass core 21 may be disposed so that the electronic elements are disposed in the cavity portion. In this case, the glass core 21 may have an electrode 63 such as a core distribution layer disposed thereon.

Next, a process of lamination on top of the first side of the second insulating layer 62 may be performed, as shown in (c) of FIG. 8. The second insulating layer 62 may be laminated over the entire first side of the glass core 21, and upon pre-curing, the second insulating layer 62 may be embedded into the inner space of the cavity portion 28, as shown in (d) of FIG. 8. For example, the second insulating layer 62 may comprise an insulating mixture, which may comprise inorganic particles and a polymeric resin. For example, the second insulating layer 62 may comprise Ajinomoto Build-up Film (ABF) as described above. Specific descriptions of each insulating layer are redundant to those described above, and therefore detailed descriptions are omitted.

If desired, the adhesive film may be removed during a subsequent process. Exemplarily, the adhesive film may be an adhesive film whose adhesion may be reduced by irradiation with ultraviolet light or the like. The adhesive film may be irradiated with ultraviolet light directly on the adhesive film or through the glass core to reduce the adhesion of the adhesive film, and the adhesive film may be easily removed from the glass core. In addition, the electronic element may be fixed in position by the second insulating layer pre-cured by curing, and if the degree of warpage is controlled below a certain level, the subsequent process can be applied without fixing the adhesive film.

Next, a process of lamination on the second side of the second insulating layer 62 may be performed, as shown in (e) of FIG. 8. The second insulating layer 62 may be laminated over the entire second side of the glass core 21, and after pre-curing, the second insulating layer 62 may be embedded into the inner space of the cavity portion 28, as shown in (f) of FIG. 8.

Thus, according to FIG. 8, in one embodiment useful for understanding the present invention, creating a cavity in a glass core 21 comprising a first surface and a second surface facing each other, and creating a cavity portion 28 through the first surface and the second surface of the glass core 21; arranging electronic elements 40 in the cavity portion 28, forming a first insulating layer 61 on some surfaces except the bottom face of the arranged electronic elements 40, and laminating a second insulating layer 62 on both the first surface and the second surface, a method of manufacturing a packaging substrate may be proposed.

In an embodiment of the present invention, a method of manufacturing a packaging substrate comprises: preparation operation of preparing a glass substrate and a cavity module having a cavity disposed thereon; and lamination operation of arranging the cavity module in the cavity portion and preparing a second insulating layer on the glass substrate.

Descriptions of glass substrates, cavity modules, etc. are redundant to those described above and are therefore omitted.

The cavity module may be manufactured by cavity module manufacturing operation.

The cavity module manufacturing operation may comprise: an arranging process for arranging electronic elements adjacent to each other; a first insulating process for providing a first insulating layer on a surface of the arranged electronic elements; and a molding process for molding the electronic elements with the first insulating layer into a molding material to provide a cavity module comprising a third insulating layer.

The cavity module manufacturing operation may further comprise forming the cavity electrodes after the molding process.

The process of forming the cavity electrode may comprise removing a portion of the molding material, forming an electrode connected to the connecting electrode of the electronic device, and arranging a cavity module connecting electrode connected to the electrode.

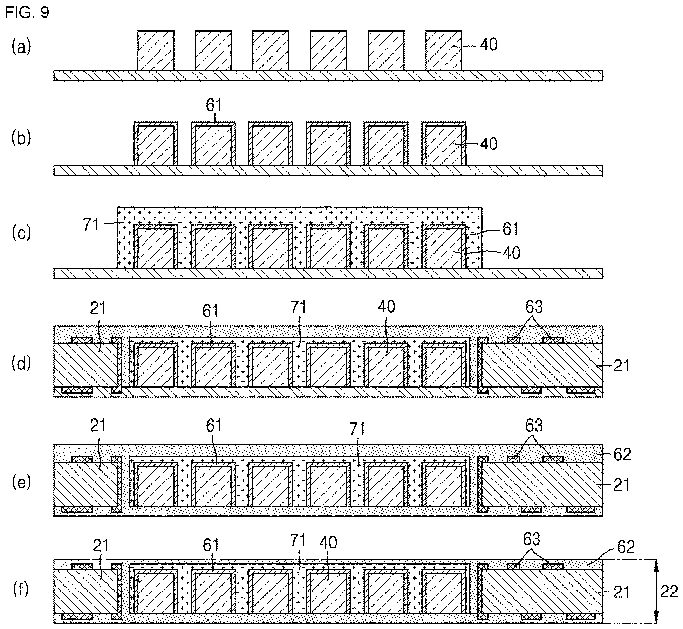

FIG. 9 is a cross-sectional flowchart illustrating a method of manufacturing a packaging substrate according to an embodiment of the present invention. Referring now to FIG. 9 for a more detailed description.

(a), (b), and (c) of FIG. 9 illustrate the operations for manufacturing a cavity module.

For example, as shown in (a) of FIG. 9, a support capable of fixing the position of the electronic element (e.g.: an adhesive film, such as PI tape (Polyimide Tape)) is prepared.

Then, as shown in (b) of FIG. 9, the first insulating layer 61 may be formed on some surfaces other than the top or bottom surfaces of the arranged electronic element 40. For example, the first insulating layer 61 may be formed by sputtering, coating, or the like on the electronic element 40. For example, one or more connection electrodes may be formed in the direction of the bottom surface of the electronic element 40. For example, one or more connection electrodes may be formed in the direction of the top surface of the electronic element 40.

Next, as shown in (c) of FIG. 9, a third insulating layer 71 comprising a molding material and arranged to wrap around the electronic elements 40 on which the first insulating layer is formed may be formed. For example, the third insulating layer 71 may be formed by injecting a molding material into the molding structure including the side walls, causing the molding material to wrap around the electronic elements 40 in which the first insulating layer is formed, and curing the molding material.

The cavity module thus produced may optionally further comprise a cavity connection electrode.

(d), (e), and (f) of FIG. 9 illustrate operations for manufacturing a packaging substrate.

As shown in (d) of FIG. 9, a cavity module may be disposed in the cavity portion 28 of the glass substrate 21, and a process of lamination on top of the second insulating layer 62 may be performed on the first surface. The second insulating layer 62 may be laminated on the entire first surface of the glass core 21, and upon pre-curing, the second insulating layer 62 may be embedded into the inner space of the cavity 28.

If desired, the process of operation (d) of FIG. 9 may be performed with an adhesive film disposed on the bottom of the glass substrate. The adhesive film may help to secure the position of the cavity module if the glass substrate has a full cavity.

The adhesive film may be removed during a subsequent process. Exemplarily, the adhesive film may be an adhesive film whose adhesion may be reduced by irradiation with ultraviolet light or the like. The adhesive film may be irradiated with ultraviolet light directly on the adhesive film or through the glass core to reduce the adhesion of the adhesive film, and the adhesive film may be easily removed from the glass core. Further, the electronic element may be fixed in position by a second insulating layer which is pre-cured by curing.

Next, a process of lamination on the second side of the second insulating layer 62 may be performed, as shown in (e) of FIG. 9. The second insulating layer 62 may be laminated on the entire second side of the glass core 21, and after pre-curing, the second insulating layer 62 may be embedded into the inner space of the cavity portion 28, as shown in (f) of FIG. 9. In the second insulating layer 62, a boundary with the third insulating layer may be observed. The boundary may be observed, in cross-section, as a line of color difference. In cross-section, the boundary may be observed in the form of a color-changing band (e.g., a gradient-like color change) having a relatively constant thickness. Exemplary, the constant thickness may be from about 2 µm to about 30 µm, such as from about 3 µm to about 10 µm.

A method of manufacturing a packaging substrate according to the embodiments described above and a packaging substrate utilizing the method can prevent an undulation phenomenon caused by a gap between elements and/or a gap between a cavity portion and an element and can prevent a leakage current from being generated in the cavity portion.

In addition, a third insulating layer having a different dielectric constant from the second insulating layer is arranged to wrap around the electronic elements formed by the first insulating layer and is formed to prevent a short circuit caused by contact between the electronic elements arranged side by side while preventing the position of the electronic elements from changing, thereby preventing the contact of the electronic elements and preventing a short circuit that may occur unintentionally during the manufacturing process of forming the electrically conductive layer.

The packaging substrate of an embodiment and a method of manufacturing the packaging substrate can significantly improve the quality of the packaging substrate by preventing undulation of the cavity portion in which the electronic element is embedded.

Furthermore, by improving the undulation phenomenon of the cavity portion, it is possible to prevent leakage current from occurring in the electronic element including the passive element and/or the active element. Additionally, by forming a first insulating layer having a dielectric constant different from the second insulating layer on all or all but one side of the electronic element, it is possible to prevent short circuits caused by contact between electronic elements disposed side by side, and to prevent short circuits that may occur unintentionally during the manufacturing process of forming an electrically conductive layer on the side of the cavity portion.

In addition, a third insulating layer having a different dielectric constant from the second insulating layer arranged to wrap around the electronic elements formed by the first insulating layer is formed to prevent a short circuit caused by contact between the electronic elements arranged side by side while preventing the position of the electronic elements from changing, thereby preventing the contact of the electronic elements and preventing a short circuit that may occur unintentionally during the manufacturing process of forming the electrically conductive layer.

The above-described invention has been described with reference to the embodiments shown in the drawings, but these are exemplary only. Accordingly, the scope of the invention is to be determined by the appended claims.

## Claims

1. A packaging substrate (20), comprising
a core layer (22) comprising a glass core (21) having first and second surfaces opposite each other and a cavity portion (28) penetrating the glass core (21);
a cavity module and a second insulating layer (62) disposed in the cavity portion (28);
wherein the cavity module comprises: a plurality of electronic elements (40), a first insulating layer (61) and a third insulating layer (71),
wherein the first insulating layer (61) covers each of the electronic elements (40) with a coating material,
wherein the first insulating layer (61) is disposed on an entire surface or an entire surface except one surface of each of the electronic elements (40);
wherein the third insulating layer (71) disposes to cover the electronic elements (40) with a molding material;
wherein the second insulating layer (62) is embedded in a portion of the cavity portion (28) excluding the cavity module; and
wherein the first insulating layer (61) and the third insulating layer (71) have different dielectric constants.

2. The packaging substrate (20) of claim 1, wherein the coating material has a lower dielectric constant than the molding material.

3. The packaging substrate (20) of claim 1 or claim 2,
wherein a high-frequency dielectric constant Dk is a dielectric constant at a high frequency of 5.8 GHz, Dk1 is a high-frequency dielectric constant of the first insulating layer (61), and Dk3 is a high-frequency dielectric constant of the third insulating layer (71), and
wherein a difference between Dk1 and Dk3 is 0.1 or more.

4. The packaging substrate (20) of any one from claim 1 to claim 3,
wherein a dielectric loss factor of the first insulating layer (61) is Df1, a dielectric loss factor of the third insulating layer (71) is Df3, and a difference between the Df1 and the Df3 is 0.0001 or more.

5. The packaging substrate (20) of any one from claim 1 to claim 4,
wherein the first insulating layer (61) has a lower dielectric constant than the second insulating layer (62), a dielectric loss factor of the first insulating layer (61) is Df1, a dielectric loss factor of the second insulating layer (62) is Df2, and a difference between the Df1 and the Df2 is 0.1 or more.

6. The packaging substrate (20) of any one from claim 1 to claim 5,
wherein a material of the first insulating layer (61) comprises an inorganic deposition layer, LCP (liquid crystal polymer), EMC (Epoxy Molding Compound), ABF (Ajinomoto Build-up Film), or MPI (Modified Polyimide).

7. The packaging substrate (20) of any one from claim 1 to claim 6,
wherein the electronic elements (40) comprise an electronic element connection electrode, the cavity module comprises a cavity connection electrode, and the cavity connection electrode is electrically connected to the electronic element connection electrode and exposed on a surface of the cavity module.

8. The packaging substrate (20) of any one from claim 1 to claim 7,
wherein the electronic elements (40) comprise passive elements, active elements, or both of them.

9. The packaging substrate (20) of any one from claim 1 to claim 8, further comprising:
a first insulating layer via disposed through the first insulating layer (61); and
a third insulating layer via disposed through at least a portion of the third insulating layer (71),
wherein at least a portion or an entirety of an inner part of the first insulating layer via and the third insulating layer via is filled with an electrode material.

10. A method of manufacturing a packaging substrate (20), comprising:
preparing operation of preparing a glass substrate (21) having a cavity portion (28) and a cavity module; and
laminating operation of arranging the cavity module in the cavity portion (28) and preparing a second insulating layer (62) on the glass substrate (21),
wherein the cavity module comprises a plurality of electronic elements (40), a first insulating layer (61), and a third insulating layer (71),
the first insulating layer (61) is covered layers of each of the electronic elements (40) with a coating material;
the first insulating layer (61) is disposed on an entire surface or an entire surface except one surface of each of the electronic elements (40); and
the third insulating layer (71) is a covered layer on the electronic elements (40) with a molding material;
wherein the second insulating layer (62) is embedded in a portion of the cavity portion (28) excluding the cavity module; and
wherein the first insulating layer (61) and the third insulating layer (71) have different dielectric constants.

11. The method of claim 10,
wherein the cavity module is manufactured by a cavity module manufacturing operation, and
the cavity module manufacturing operation comprises:
arranging process of arranging electronic elements (40) adjacent to each other;
first insulating process of preparing a first insulating layer (61) on a surface of the arranged electronic elements (40); and
molding process of molding the electronic elements (40) on which the first insulating layer (61) is prepared with a molding material to prepare a cavity module comprising the third insulating layer (71).

12. The method of claim 10 or claim 11,
wherein the molding material comprises EMC (Epoxy Molding Compound), ABF (Ajinomoto Build-up Film), or MPI (Modified Polyimide).

13. The method of any one from claim 10 to claim 12,
wherein the cavity module manufacturing operation further comprises a cavity electrode forming process after the molding process, and
the cavity electrode forming process is a process of removing a portion of the molding material, forming an electrode connected to a connection electrode of the electronic element (40), and arranging a cavity module connection electrode connected to the electrode.

## Patentansprüche

1. Verpackungssubstrat (20), umfassend
eine Kernschicht (22), umfassend einen Glaskern (21) mit einer ersten und einer zweiten Oberfläche, die einander gegenüberliegen, und einen Hohlraumabschnitt (28), der den Glaskern (21) durchdringt;
ein Hohlraummodul und eine zweite Isolierschicht (62), die in dem Hohlraumabschnitt (28) angeordnet ist;
wobei das Hohlraummodul umfasst: eine Vielzahl von elektronischen Elementen (40), eine erste Isolierschicht (61) und eine dritte Isolierschicht (71),
wobei die erste Isolierschicht (61) jedes der elektronischen Elemente (40) mit einem Beschichtungsmaterial bedeckt,
wobei die erste Isolierschicht (61) auf einer gesamten Oberfläche oder einer gesamten Oberfläche mit Ausnahme einer Oberfläche jedes der elektronischen Elemente (40) angeordnet ist;
wobei die dritte Isolierschicht (71) angeordnet ist, um die elektronischen Elemente (40) mit einem Formmaterial zu bedecken;
wobei die zweite Isolierschicht (62) in einem Abschnitt des Hohlraumabschnitts (28) mit Ausnahme des Hohlraummoduls eingebettet ist; und
wobei die erste Isolierschicht (61) und die dritte Isolierschicht (71) unterschiedliche Dielektrizitätskonstanten aufweisen.

2. Verpackungssubstrat (20) nach Anspruch 1, wobei das Beschichtungsmaterial eine niedrigere Dielektrizitätskonstante als das Formmaterial aufweist.

3. Verpackungssubstrat (20) nach Anspruch 1 oder Anspruch 2,
wobei eine Hochfrequenz-Dielektrizitätskonstante Dk eine Dielektrizitätskonstante bei einer hohen Frequenz von 5,8 GHz ist, Dk1 eine Hochfrequenz-Dielektrizitätskonstante der ersten Isolierschicht (61) ist und Dk3 eine Hochfrequenz-Dielektrizitätskonstante der dritten Isolierschicht (71) ist, und
wobei eine Differenz zwischen Dk1 und Dk3 0,1 oder mehr beträgt.

4. Verpackungssubstrat (20) nach einem von Anspruch 1 bis Anspruch 3,
wobei ein dielektrischer Verlustfaktor der ersten Isolierschicht (61) Df1 ist, ein dielektrischer Verlustfaktor der dritten Isolierschicht (71) Df3 ist und eine Differenz zwischen Df1 und Df3 0,0001 oder mehr beträgt.

5. Verpackungssubstrat (20) nach einem von Anspruch 1 bis Anspruch 4,
wobei die erste Isolierschicht (61) eine niedrigere Dielektrizitätskonstante als die zweite Isolierschicht (62) aufweist, ein dielektrischer Verlustfaktor der ersten Isolierschicht (61) Df1 ist, ein dielektrischer Verlustfaktor der zweiten Isolierschicht (62) Df2 ist und eine Differenz zwischen Df1 und Df2 0,1 oder mehr beträgt.

6. Verpackungssubstrat (20) nach einem von Anspruch 1 bis Anspruch 5,
wobei ein Material der ersten Isolierschicht (61) eine anorganische Abscheidungsschicht, LCP (Flüssigkristallpolymer), EMC (Epoxidformverbindung), ABF (Ajinomoto Aufbaufilm) oder MPI (Modifiziertes Polyimid) umfasst.

7. Verpackungssubstrat (20) nach einem von Anspruch 1 bis Anspruch 6,
wobei die elektronischen Elemente (40) eine Verbindungselektrode für elektronische Elemente umfassen, das Hohlraummodul eine Hohlraumverbindungselektrode umfasst und die Hohlraumverbindungselektrode elektrisch mit der Verbindungselektrode für elektronische Elemente verbunden und auf einer Oberfläche des Hohlraummoduls freigelegt ist.

8. Verpackungssubstrat (20) nach einem von Anspruch 1 bis Anspruch 7,
wobei die elektronischen Elemente (40) passive Elemente, aktive Elemente oder beides davon umfassen.

9. Verpackungssubstrat (20) nach einem von Anspruch 1 bis Anspruch 8, ferner
umfassend:
eine erstes Isolierschichtkontaktloch, das durch die erste Isolierschicht (61) angeordnet ist; und
ein drittes Isolierschichtkontaktloch, das durch mindestens einen Abschnitt der dritten Isolierschicht (71) angeordnet ist,
wobei mindestens ein Abschnitt oder eine Gesamtheit eines inneren Teils des ersten Isolierschichtkontaktlochs und des dritten Isolierschichtkontaktlochs mit einem Elektrodenmaterial gefüllt ist.

10. Verfahren zum Herstellen eines Verpackungssubstrats (20), umfassend:
einen Erstellungsvorgang zum Erstellen eines Glassubstrats (21) mit einem Hohlraumabschnitt (28) und einem Hohlraummodul; und
einen Laminiervorgang zum Anordnen des Hohlraummoduls in dem Hohlraumabschnitt (28) und zum Erstellen einer zweiten Isolierschicht (62) auf dem Glassubstrat (21),
wobei das Hohlraummodul eine Vielzahl von elektronischen Elementen (40), eine erste Isolierschicht (61) und eine dritte Isolierschicht (71) umfasst,
die erste Isolierschicht (61) bedeckte Schichten von jedem der elektronischen Elemente (40) mit einem Beschichtungsmaterial ist;
die erste Isolierschicht (61) auf einer gesamten Oberfläche oder einer gesamten Oberfläche mit Ausnahme einer Oberfläche jedes der elektronischen Elemente (40) angeordnet ist; und
die dritte Isolierschicht (71) eine bedeckte Schicht auf den elektronischen Elementen (40) mit einem Formmaterial ist;
wobei die zweite Isolierschicht (62) in einem Abschnitt des Hohlraumabschnitts (28) mit Ausnahme des Hohlraummoduls eingebettet ist; und
wobei die erste Isolierschicht (61) und die dritte Isolierschicht (71) unterschiedliche Dielektrizitätskonstanten aufweisen.

11. Verfahren nach Anspruch 10,
wobei das Hohlraummodul durch einen Hohlraummodulherstellungsvorgang hergestellt wird, und
der Hohlraummodulherstellungsvorgang umfasst:
einen Anordnungsprozess zum Anordnen von elektronischen Elementen (40) benachbart zueinander;
einen ersten Isolierprozess zum Erstellen einer ersten Isolierschicht (61) auf einer Oberfläche der angeordneten elektronischen Elemente (40); und
einen Formprozess zum Formen der elektronischen Elemente (40), auf denen die erste Isolierschicht (61) erstellt ist, mit einem Formmaterial, um ein Hohlraummodul herzustellen, das die dritte Isolierschicht (71) umfasst.

12. Verfahren nach Anspruch 10 oder Anspruch 11,
wobei das Formmaterial EMC (Epoxidformverbindung), ABF (Ajinomoto Aufbaufilm) oder MPI (Modifiziertes Polyimid) umfasst.

13. Verfahren nach einem von Anspruch 10 bis Anspruch 12,
wobei der Hohlraummodulherstellungsvorgang ferner einen Hohlraumelektrodenbildungsprozess nach dem Formprozess umfasst, und
der Hohlraumelektrodenbildungsprozess ein Prozess zum Entfernen eines Abschnitts des Formmaterials, zum Bilden einer Elektrode, die mit einer Verbindungselektrode des elektronischen Elements (40) verbunden ist, und zum Anordnen einer Hohlraummodulverbindungselektrode, die mit der Elektrode verbunden ist, ist.

## Revendications

1. Substrat d'encapsulation (20), comprenant :
une couche centrale (22) comprenant une âme en verre (21) présentant une première et une deuxième surfaces opposées l'une à l'autre et une partie de cavité (28) traversant l'âme en verre (21) ;
un module de cavité et une deuxième couche isolante (62) disposée dans la partie de cavité (28) ;
où le module de cavité comprend : une pluralité de composants électroniques (40), une première couche isolante (61) et une troisième couche isolante (71),
où la première couche isolante (61) recouvre chacun des composants électroniques (40) d'un matériau de revêtement,
où la première couche isolante (61) est disposée sur toute la surface ou sur toute la surface à l'exception de la surface de chacun des composants électroniques (40) ;
où la troisième couche isolante (71) est disposée de manière à recouvrir les composants électroniques (40) d'un matériau de moulage ;
où la deuxième couche isolante (62) est intégrée dans une partie de la partie de cavité (28), à l'exclusion du module de cavité ; et
où la première couche isolante (61) et la troisième couche isolante (71) ont des constantes diélectriques différentes.

2. Substrat d'encapsulation (20) selon la revendication 1, où le matériau de revêtement a une constante diélectrique inférieure à celle du matériau de moulage.

3. Substrat d'encapsulation (20) selon la revendication 1 ou la revendication 2,
où une constante diélectrique haute fréquence Dk est une constante diélectrique à une fréquence élevée de 5,8 GHz, Dk1 est une constante diélectrique haute fréquence de la première couche isolante (61) et Dk3 est une constante diélectrique haute fréquence de la troisième couche isolante (71), et
où la différence entre Dk1 et Dk3 est de 0,1 ou plus.

4. Substrat d'encapsulation (20) selon l'une des revendications 1 à 3,
où le facteur de perte diélectrique de la première couche isolante (61) est Df1, le facteur de perte diélectrique de la troisième couche isolante (71) est Df3 et la différence entre Df1 et Df3 est de 0,0001 ou plus.

5. Substrat d'encapsulation (20) selon l'une des revendications 1 à 4,
où la première couche isolante (61) a une constante diélectrique inférieure à celle de la deuxième couche isolante (62), le facteur de perte diélectrique de la première couche isolante (61) est Df1, le facteur de perte diélectrique de la deuxième couche isolante (62) est Df2, et la différence entre Df1 et Df2 est de 0,1 ou plus.

6. Substrat d'encapsulation (20) selon l'une des revendications 1 à 5,
où le matériau de la première couche isolante (61) comprend une couche de dépôt inorganique, LCP (polymère à cristaux liquides), EMC (composé de moulage époxy), ABF (film de construction Ajinomoto), ou MPI (polyimide modifié).

7. Substrat d'encapsulation (20) selon l'une des revendications 1 à 6,
où les composants électroniques (40) comprennent une électrode de connexion de composants électroniques, le module de cavité comprend une électrode de connexion de cavité, et l'électrode de connexion de cavité est connectée électriquement à l'électrode de connexion de composants électroniques et exposée sur une surface du module de cavité.

8. Substrat d'encapsulation (20) selon l'une des revendications 1 à 7,
où les composants électroniques (40) comprennent des éléments passifs, des éléments actifs, ou les deux.

9. Substrat d'encapsulation (20) selon l'une des revendications 1 à 8, comprenant en outre :
un premier trou d'interconnexion de couche isolante ménagé dans la première couche isolante (61) ; et
un troisième trou d'interconnexion de couche isolante ménagé dans au moins une partie de la troisième couche isolante (71),
où au moins une partie ou la totalité d'une partie intérieure du premier trou d'interconnexion de couche isolante et du troisième trou d'interconnexion de couche isolante est remplie d'un matériau d'électrode.

10. Procédé de fabrication d'un substrat d'encapsulation (20), comprenant :
la préparation d'une opération de préparation d'un substrat en verre (21) ayant une partie de cavité (28) et un module de cavité ; et
une opération de stratification consistant à disposer le module de cavité dans la partie de cavité (28), et la préparation d'une deuxième couche isolante (62) sur le substrat en verre (21),
où le module de cavité comprend une pluralité de composants électroniques (40), une première couche isolante (61) et une troisième couche isolante (71),
la première couche isolante (61) recouvre les couches de chacun des composants électroniques (40) d'un matériau de revêtement ;
la première couche isolante (61) est disposée est disposée sur toute la surface ou sur toute la surface à l'exception de la surface de chacun des composants électroniques (40) ; et
la troisième couche isolante (71) est une couche de couverture des composants électroniques (40) avec un matériau de moulage ;
où la deuxième couche isolante (62) est intégrée dans une partie de la partie de cavité (28), à l'exclusion du module de cavité ; et
où la première couche isolante (61) et la troisième couche isolante (71) ont des constantes diélectriques différentes.

11. Procédé selon la revendication 10,
où le module de cavité est fabriqué par une opération de fabrication de module de cavité, et
où l'opération de fabrication du module de cavité comprend :
un processus d'agencement de composants électroniques (40) adjacents les uns aux autres ;
un premier procédé d'isolation consistant à préparer une première couche isolante (61) sur une surface des composants électroniques agencés (40) ; et
un procédé de moulage consistant à mouler les composants électroniques (40) sur lesquels la première couche isolante (61) est préparée avec un matériau de moulage afin de préparer un module de cavité comprenant la troisième couche isolante (71).

12. Procédé selon la revendication 10 ou la revendication 11,
où le matériau de moulage comprend un EMC (composé de moulage époxy), un ABF (film de construction Ajinomoto), ou un MPI (polyimide modifié).

13. Procédé selon l'une des revendications 10 à 12,
où l'opération de fabrication du module de cavité comprenant en outre un processus de formation d'électrode à cavité après le processus de moulage, et
le processus de formation d'électrode à cavité est un processus consistant à retirer une partie du matériau de moulage, à former une électrode connectée à une électrode de connexion de composant électronique (40), et à disposer une électrode de connexion de module de cavité connectée à l'électrode.
